# EUROPEAN PATENT SPECIFICATION

(11) **EP 3 900 056 B1**
(45) Date of publication and mention of the grant of the patent: **28.05.2025**
(21) Application number: 19856480.9
(22) Date of filing: 20.12.2019
(51) Int. Cl.: H01L 33/44, H01L 33/56, H01L 33/50, H01L 33/58, H01L 33/60

(54) **LED PACKAGE WITH INCREASED CONTRAST RATIO AND METHOD OF MANUFACTURING THE SAME**
LED-GEHÄUSE MIT ERHÖHTEM KONTRASTVERHÄLTNIS UND VERFAHREN ZU DESSEN HERSTELLUNG
BOÎTIER DE DEL AYANT UN RAPPORT DE CONTRASTE ÉLEVÉ ET PROCÉDÉ DE SA FABRICATION

(30) Priority: 21.12.2018 US 201862783973 P; 11.02.2019 EP 19156328; 19.12.2019 US 201916720636
(43) Date of publication of application: 27.10.2021
(73) Proprietor: Lumileds Holding B.V., 1118 CL Schiphol (NL)
(72) Inventor: BASIN, Grigoriy, San Jose, CA 95131 (US); KOSOWSKY, Lex, Alan, San Jose, CA 95131 (US); FOUKSMAN, Michael, San Jose, CA 95131 (US)
(74) Representative: dompatent von Kreisler Selting Werner - Partnerschaft von Patent- und Rechtsanwälten mbB
(86) International application number: PCT/IB2019/001411
(87) International publication number: WO 2020/128631

(56) References cited:
- WO-A1-2014/081042
- WO-A1-2014/081042
- JP-A- 2010 157 638
- JP-A- 2010 157 638
- US-A1- 2011 018 017
- US-A1- 2015 280 081
- US-A1- 2015 280 081
- US-A1- 2017 324 010

## Description

### CROSS-REFERENCE TO RELATED APPLICATIONS

This application claims benefit of priority to U.S. Patent Application 16/720,636 filed December 19, 2019, to European Patent Application 19156328.7 filed February 11, 2019, and to U.S. Provisional Patent Application 62/783,973 filed December 21, 2018.

### TECHNICAL FIELD

The present disclosure generally relates to manufacture of LED modules having reflective sidewalls and an improved contrast ratio. In one embodiment, a light absorbing black area is screen printed around an LED stack.

### BACKGROUND

Semiconductor light-emitting diodes and laser diodes (both referred to herein as LEDs) can be manufactured to include a combination of an LED with a relatively thick ceramic phosphor or a phosphor embedded in silicone. Light passes from a top of the LED through the phosphor layer, with some percentage being wavelength converted to provide a needed light spectral output. Typically, some proportion of the light is effectively wasted by reflection or direct transmission out the side of the LED, rather than the top of LED. To minimize this waste, reflective materials can be used to reflect side emitted light back into the phosphor. For example, one common packaging technique uses an overmold side coat process that encapsulates LED/phosphor sidewalls with highly reflective light material. Such encapsulation also acts as light reflector to provide sharp luminance cut-off outside of light emitting area, minimize the amount of stray light, and improve near-field contrast.

Even with such overmold packaging, near-field contrast can be reduced by stray light scattered by a submount, by light that is side scattered and reflected from phosphor, or by phosphor sidewall light due to partial exposure of the phosphor sidewall during bead blast processing or cleaning. This contrast reducing stray light can be particularly detrimental for applications with primary or secondary optics, including camera flash modules, automotive front lighting, and other light projection systems.

Attempts have been made to increase contrast by creating light absorbing lines or regions around the LED. For example, a light reflective material can be arranged to cover the sidewall of the LED and the phosphor. Using a marking laser, a light absorbing layer can be created by heating the light reflective material. In some embodiments, this light absorbing layer can be positioned to at least partially surround the phosphor and define a gap therebetween. Unfortunately, such laser marked lines can also penetrate a significant distance into the depth of the side coated material, causing unacceptable light loss.

US 2011/018017 discloses a LED package, wherein the LED is surrounded by a retainer, wherein the LED comprises a reflective layer at its sidewalls disposed between the LED and the retainer in order to prevent undesired light emission by the retainer.

US 2017/0324010 A1 discloses a LED package, wherein a LED is covered by a color conversion material, whereby the LED and the covering color-conversion material are surrounded by a reflective material having an upper surface that is coplanar with the upper surface of the color-conversion material. The reflective material is covered by a light-blocking material.

### SUMMARY

In accordance with embodiments of the invention as defined in claim 1, a LED package can include a top emitting LED having a top and a sidewall. A phosphor layer (more generally, a wavelength converting structure) having a top side and sidewall is attached to the top emitting LED, together forming a phosphor-converted LED, and a sacrificial layer is used to provide a protective covering on top the phosphor layer. A light reflective material is arranged to cover the sidewall of the LED and the phosphor layer, and a light absorbing layer is positioned on the light reflective material to at least partially surround the sacrificial layer and phosphor layer and define a gap therebetween of between 30 to 60 microns. Advantageously, this structure ensures that LED and phosphor layer side walls are not exposed, absorbs light guided through bulk of the reflective side coat, eliminates glare, and significantly improves near-field contrast of the LED package.

In some embodiments, the phosphor layer is a ceramic phosphor (for example a ceramic phosphor platelet), while in others it is a block of phosphor particles bound together with silicone, epoxy, or other suitable binding agents.

In some embodiments, the light reflective material includes at least one or more of SiO₂, Al₂O₃ and TiO₂. The light reflective material can include silicone rubber as a binding agent.

In some embodiments, the sacrificial layer is transparent. In other embodiments, the sacrificial layer can be completely removed prior to screen printing. In still other embodiments, the sacrificial lay is not necessary if fine control of the grinding and polishing process is available.

In other embodiments, a method according to claim 11 is described for providing an LED package including a LED stack having an LED, a phosphor layer, and a sacrificial layer, the LED stack having a top and a sidewall. The top and sidewall of the LED stack are covered with a light reflective material, followed by removal of any excess light reflective material from the top of the LED stack. Using screen printing or other suitable techniques, a light absorbing layer is on the light reflective material, with the deposited light absorbing layer at least partially surrounding the LED stack and defining a gap therebetween of between 30 and 60 microns.

In some embodiments of the method, excess light reflective material can be removed by a grinding and planarizing step.

In other embodiments, the step of depositing a light absorbing layer on the light reflective material further comprises the step of depositing a removable patterning layer defining cavities for infill of the light absorbing layer. This allows use of screen printing techniques where the light absorbing material is scraped by a blade moved across the pattern, infilling the cavities. Alternatively, ink jet or other suitable deposition methods can be used.

In some embodiments, the protective sacrificial layer can be removed by etch or wash after printing the light absorbing layer.

### BRIEF DESCRIPTION OF THE DRAWINGS

Non-limiting and non-exhaustive embodiments of the present disclosure are described with reference to the following figures, wherein like reference numerals refer to like parts throughout the various figures unless otherwise specified.
FIG. 1 shows a schematic cross-sectional view of an example pcLED.
FIGS. 2A and 2B show, respectively, cross-sectional and top schematic views of an array of pcLEDs.
FIG. 3A shows a schematic top view an electronics board on which an array of pcLEDs may be mounted, and FIG. 3B similarly shows an array of pcLEDs mounted on the electronic board of FIG. 3A.
FIG. 4A shows a schematic cross sectional view of an array of pcLEDs arranged with respect to waveguides and a projection lens. FIG. 4B shows an arrangement similar to that of FIG. 4A, without the waveguides.
FIG. 5 is a flow chart illustrating an example process for manufacture of a high contrast LED package.
FIGS. 6A, 6B, 6C, and 6D illustrate steps in an example embodiment of manufacturing steps for a high contrast LED package.

### DETAILED DESCRIPTION

The following detailed description should be read with reference to the drawings, in which identical reference numbers refer to like elements throughout the different figures. The drawings, which are not necessarily to scale, depict selective embodiments and are not intended to limit the scope of the invention. The detailed description illustrates by way of example, not by way of limitation, the principles of the invention.

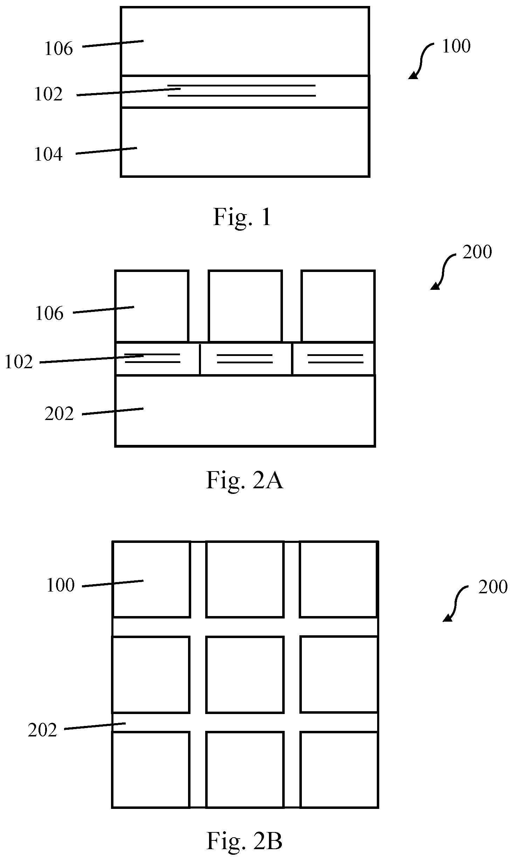

Figure 1 shows an example of an individual pcLED 100 comprising a semiconductor diode structure 102 disposed on a substrate 104, together considered herein an "LED", and a phosphor layer 106 disposed on the LED. Semiconductor diode structure 102 typically comprises an active region disposed between n-type and p-type layers. Application of a suitable forward bias across the diode structure results in emission of light from the active region. The wavelength of the emitted light is determined by the composition and structure of the active region.

The LED may be, for example, a III-Nitride LED that emits blue, violet, or ultraviolet light. LEDs formed from any other suitable material system and that emit any other suitable wavelength of light may also be used. Other suitable material systems may include, for example, III-Phosphide materials, III-Arsenide materials, and II-VI materials.

Any suitable phosphor materials may be used, depending on the desired optical output from the pcLED.

Figures 2A-2B show, respectively, cross-sectional and top views of an array 200 of pcLEDs 100 including phosphor pixels 106 disposed on a substrate 202. Such an array may include any suitable number of pcLEDs arranged in any suitable manner. In the illustrated example the array is depicted as formed monolithically on a shared substrate, but alternatively an array of pcLEDs may be formed from separate individual pcLEDs. Substrate 202 may optionally comprise CMOS circuitry for driving the LED, and may be formed from any suitable materials.

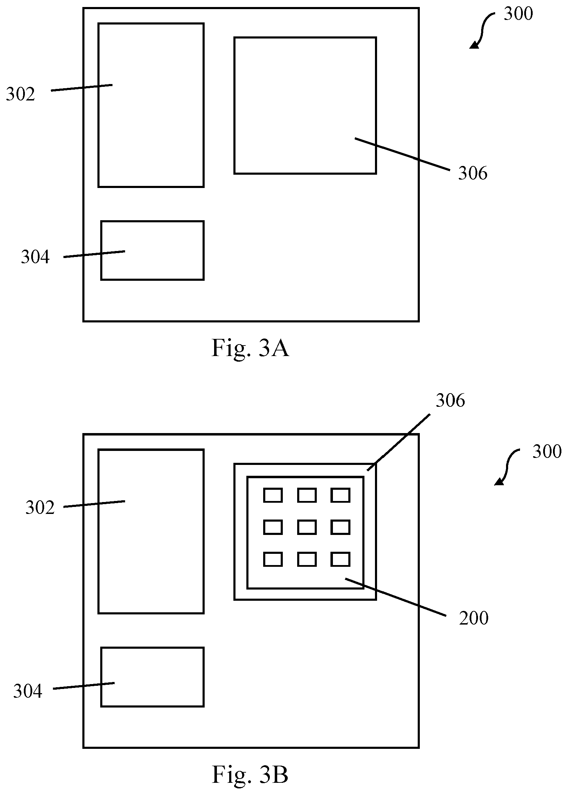

As shown in Figures 3A-3B, a pcLED array 200 may be mounted on an electronics board 300 comprising a power and control module 302, a sensor module 304, and an LED attach region 306. Power and control module 302 may receive power and control signals from external sources and signals from sensor module 304, based on which power and control module 302 controls operation of the LEDs. Sensor module 304 may receive signals from any suitable sensors, for example from temperature or light sensors. Alternatively, pcLED array 200 may be mounted on a separate board (not shown) from the power and control module and the sensor module.

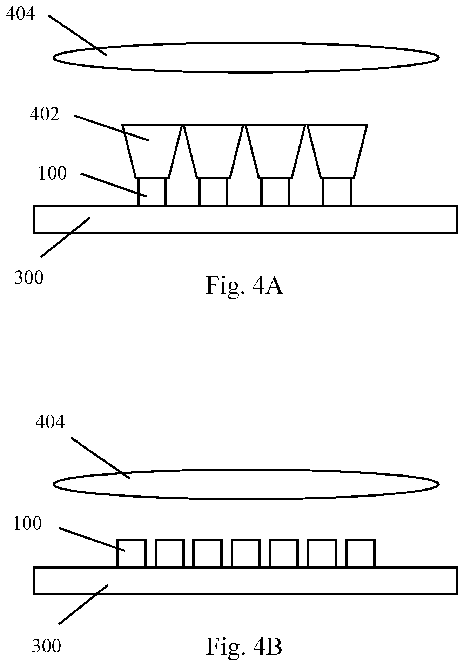

Individual pcLEDs may optionally incorporate or be arranged in combination with a lens or other optical element located adjacent to or disposed on the phosphor layer. Such an optical element, not shown in the figures, may be referred to as a "primary optical element". In addition, as shown in Figures 4A-4B a pcLED array 200 (for example, mounted on an electronics board 300) may be arranged in combination with secondary optical elements such as waveguides, lenses, or both for use in an intended application. In Figure 4A, light emitted by pcLEDs 100 is collected by waveguides 402 and directed to projection lens 404. Projection lens 404 may be a Fresnel lens, for example. This arrangement may be suitable for use, for example, in automobile headlights. In Figure 4B, light emitted by pcLEDs 100 is collected directly by projection lens 404 without use of intervening waveguides. This arrangement may particularly be suitable when pcLEDs can be spaced sufficiently close to each other, and may also be used in automobile headlights as well as in camera flash applications. A microLED display application may use similar optical arrangements to those depicted in Figures 4A-4B, for example. Generally, any suitable arrangement of optical elements may be used in combination with the pcLEDs described herein, depending on the desired application.

For many uses of pcLED arrays, it is desirable to compartmentalize the light emitted from the individual pcLEDs in the array. That is, it is advantageous to be able to operate an individual pcLED in the array as a light source while adjacent pcLEDs in the array remain dark. This allows for better control of displays or of illumination.

It is also advantageous in many applications to place the pcLEDs in the array close together. For example, a preferred configuration in microLEDs is to have minimal spacing between the individual LEDs. Closely spacing the pcLEDs in an array used as a camera flash light source or in an automobile headlight may simplify the requirements on any secondary optics and improve the illumination provided by the array.

However, if pcLEDs in an array are placed close together, optical cross talk between adjacent pcLEDs may occur. That is, light emitted by a pcLED may scatter into or otherwise couple into an adjacent pcLED and appear to originate from that other pcLED, preventing the desired compartmentalization of light and reducing contrast between adjacent pixels.

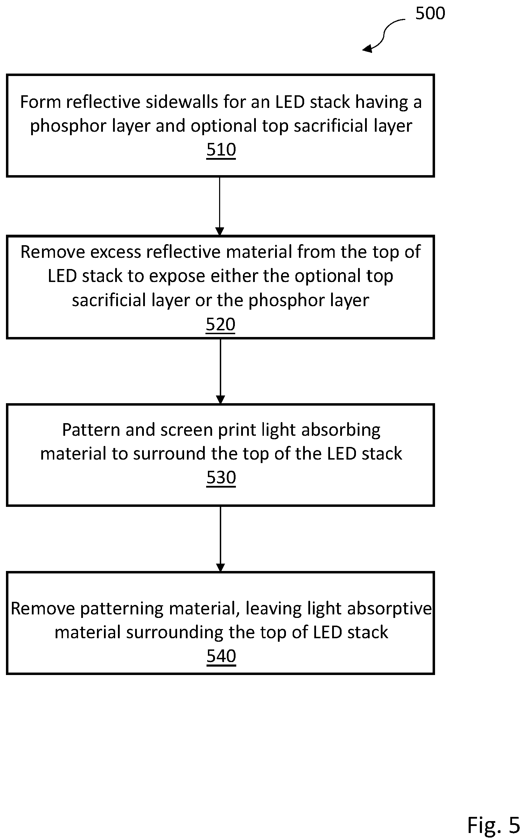

As seen in FIG. 5, a process 500 describes a method of manufacturing LED modules with increased contrast ratio by using a selective grinding and screen print process. A light reflective material that covers LED sidewalls is provided to overmould an LED stack including an LED, a phosphor material such as a wavelength conversion ceramic, and an optional transparent sacrificial layer on the wavelength conversion ceramic (step 510). This overmoulded light reflective material covers sidewalls and top of the LED stack. The top surface is ground flat to expose the top sacrificial layer of the LED stack (step 520). Advantageously, the transparent sacrificial layer on the wavelength conversion ceramic protects the surface during grinding. In those embodiments manufacturable with closely controlled grinding or polishing processes, the sacrificial layer can be omitted. A light absorbing material is screen printed on the light reflective material surrounding the LED stack (step 530), and then any patterning material used in the screen printing process is removed (step 540). In accordance with the claimed invention, a gap (661) is defined between the light absorbing material and the LED stack of between 30 and 60 microns. Maintaining this narrow gap reduces potential light loss from the LED stack. In a final step, the patterning material can be removed, leaving light absorbing material surrounding the top of LED stack.

The LED can include a substrate formed of sapphire or silicon carbide that is able to support an epitaxially grown or deposited semiconductor n-layer. A semiconductor p-layer can be sequentially grown or deposited on the n-layer, forming an active region at the junction between layers. Semiconductor materials capable of forming high-brightness light emitting devices can include, but are not limited to, Group III-V semiconductors, particularly binary, ternary, and quaternary alloys of gallium, aluminum, indium, and nitrogen, also referred to as III-nitride materials.

In addition to ceramic material containing phosphors, phosphors in the LED stack can be bound together with silicone or other suitable binders. Phosphors can include one or more wavelength converting materials able to create white light or monochromatic light of other colors. All or only a portion of the light emitted by the LED may be converted by the wavelength converting material of the phosphor. Unconverted light may be part of the final spectrum of light, though it need not be. Examples of common devices include a blue-emitting LED segment combined with a yellow-emitting phosphor, a blue-emitting LED segment combined with green- and red-emitting phosphors, a UV-emitting LED segment combined with blue- and yellow-emitting phosphors, and a UV-emitting LED segment combined with blue-, green-, and red-emitting phosphors.

The light reflective material can include particles bound together using silicone or other suitable binders. Light reflective material can also include organic, inorganic, or organic/inorganic binder and filler material. For example, organic/inorganic binder and filler can be, for example, silicone with embedded reflective titanium oxide (TiO₂), SiO₂, or other reflective/scattering particles. Inorganic binders can include sol-gel (e.g., a sol-gel of TEOS or MTMS) or liquid glass (e.g., sodium silicate or potassium silicate), also known as water glass. In some embodiments, binders can include fillers that adjust physical properties. Fillers can include inorganic nanoparticles, silica, glass particles or fibers, or other materials able to improve optical or thermal performance. The light reflective material can be applied to the sidewalls by various processes, including moulding, dispensing, screen printing, spray, or lamination (for reflective particles in a binder).

As noted above, in still other embodiments primary or secondary optics can be attached or positioned near the LED package. Optics can include concave or convex lenses, lenslet arrays, graded index lens, reflectors, scattering elements, beam homogenizers, diffusers, or other light focusing or blurring optics. Protective layers, transparent layers, thermal layers, or other packaging structures can be used as needed for specific applications.

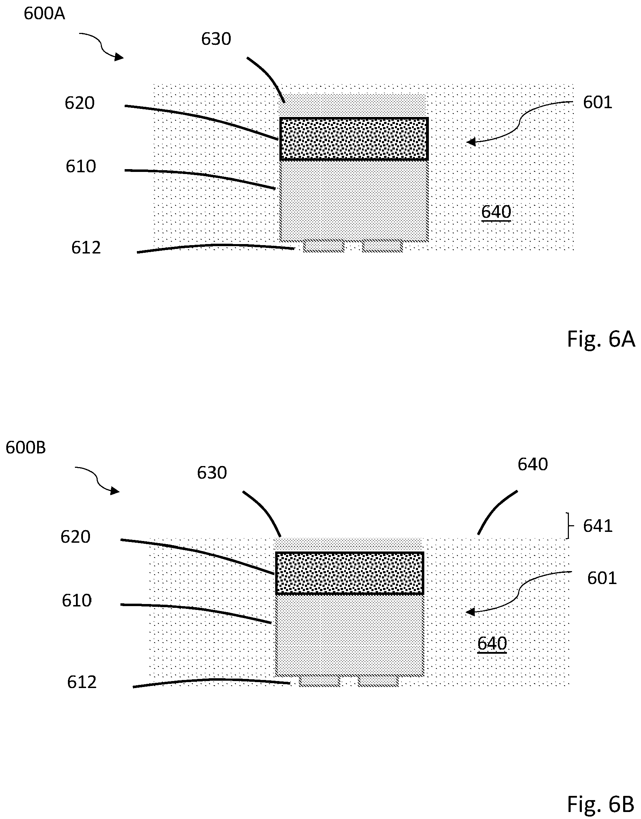

As seen in FIGS. 6A-6D, a process is described for forming a LED package 600A with an LED stack 601 surrounded by light reflective material 640. As seen in FIG. 6A, LED stack 600A includes a light emitting semiconductor LED 610 with electrical contacts 612. A phosphor layer 620 is positioned on top of LED 610, and an optional sacrificial layer 630 is positioned on top of phosphor layer 620. The sacrificial layer can be a thin and transparent layer of silicone or epoxy that protects the phosphor layer 620 from damage to surface properties or microstructures by later grinding or polishing steps. In some embodiments the sacrificial layer can be omitted, or if present, entirely removed during grinding or polishing steps. The LED structure is overmoulded with light reflective material 640 that covers sidewalls and top of the LED stack 201, exposing only the electrical contacts 612.

FIG 6B illustrates LED package 600B defined from LED package 600A of FIG. 6A after removal of excess overmoulded light reflective material from the top of the LED stack 601. This can be done by grind or polish, and typically results in removal of a small amount (indicated by depth 641) of the sacrificial layer 630 and the light reflective material 640.

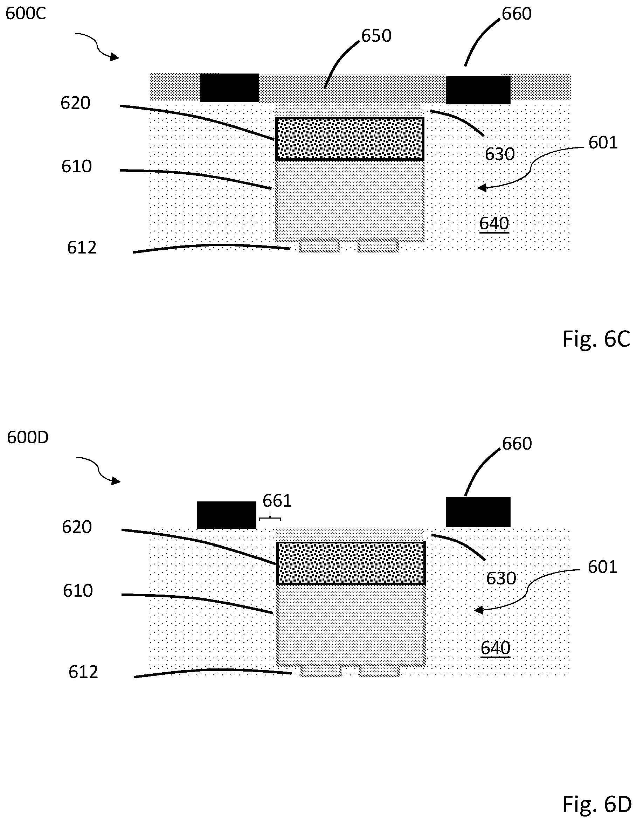

FIG. 6C illustrates LED package 600C defined from LED package 600B of FIG. 6B after application of a patterned screen printing layer 650. Cavities channels, or grooves defined by the patterned screen printing layer 650 can be infilled with a light absorbing material 660 such as silicone, epoxy, or other binder containing carbon black or other light absorbing particles or dyes.

FIG. 6D illustrates a structure 600D after removal of the patterned screen printing layer 650. Light absorbing material is positioned at a distance (gap) 661 of between 30 to 60 microns from an edge of the LED stack and sacrificial layer 630.

In addition to use in conventional LED lighting applications, packaged LEDs and/or packaged LED arrays such as disclosed herein may support a wide range of applications that benefit from fine-grained intensity, spatial, and temporal control of light distribution. This may include, but is not limited to, precise spatial patterning of emitted light from blocks or individual LEDs. Depending on the application, emitted light may be spectrally distinct, adaptive over time, and/or environmentally responsive. In some embodiments, LEDS may provide pre-programmed light distribution in various intensity, spatial, or temporal patterns. The emitted light may be based at least in part on received sensor data and may be used for optical wireless communications. Associated optics may be distinct at single or multiple LED level. An example light emitting array may include a device having a commonly controlled central block of high intensity LEDS with an associated common optic, whereas edge positioned LEDs may have individual optics. Common applications supported by light emitting LED arrays include video lighting, automotive headlights, architectural and area illumination, street lighting, and informational displays.

Programmable light emitting arrays may be used to selectively and adaptively illuminate buildings or areas for improved visual display or to reduce lighting costs. In addition, light emitting arrays may be used to project media facades for decorative motion or video effects. In conjunction with tracking sensors and/or cameras, selective illumination of areas around pedestrians may be possible. Spectrally distinct LEDs may be used to adjust the color temperature of lighting, as well as support wavelength specific horticultural illumination.

Street lighting is an important application that may greatly benefit from use of programmable light emitting arrays. A single type of light emitting array may be used to mimic various street light types, allowing, for example, switching between a Type I linear street light and a Type IV semicircular street light by appropriate activation or deactivation of selected LEDs. In addition, street lighting costs may be lowered by adjusting light beam intensity or distribution according to environmental conditions or time of use. For example, light intensity and area of distribution may be reduced when pedestrians are not present. If LEDs of the light emitting array are spectrally distinct, the color temperature of the light may be adjusted according to respective daylight, twilight, or night conditions.

Programmable light emitting LEDs are also well suited for supporting applications requiring direct or projected displays. For example, automotive headlights requiring calibration, or warning, emergency, or informational signs may all be displayed or projected using light emitting arrays. This allows, for example, modifying directionality of light output from an automotive headlight. If a light emitting array is composed of a large number of LEDs or includes a suitable dynamic light mask, textual or numerical information may be presented with user guided placement. Directional arrows or similar indicators may also be provided.

Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, but includes modifications and embodiments falling within the scope of the appended claims. It is also understood that other embodiments of this invention may be practiced in the absence of an element/step not specifically disclosed herein, if only such embodiments fall within the scope defined by the appended claims.

## Claims

1. A light emitting device (600D) comprising:
a light emitting diode (610) comprising a top light emitting surface, an oppositely positioned bottom surface, and side surfaces connecting the top and bottom surfaces;
a wavelength converting structure (620) comprising a top light emitting surface, an oppositely positioned bottom surface, and side surfaces connecting the top and bottom surfaces, the wavelength converting structure bottom surface disposed on or adjacent to the light emitting diode top surface;
a reflective structure (640) comprising a reflective material disposed on the side surfaces of the light emitting diode and on side surfaces of the wavelength converting structure, the reflective structure comprising a planar top surface arranged adjacent to and parallel to the top surface of the wavelength converting structure, the planar top surface being disposed at a same level as the top surface of the wavelength converting structure or above the top surface of the wavelength converting structure in a vertical direction perpendicular to the planar top surface; and
a light absorbing layer (660) positioned on the planar top surface of the reflective structure, and separated from outer edges of the top surface of the wavelength converting phosphor structure by a gap (661) having a width of between 30 microns and 60 microns measured perpendicularly to a side surface of the wavelength converting phosphor structure.

2. The light emitting device of claim 1, wherein the planar top surface of the reflective structure (640) is coplanar with the top light emitting surface of the wavelength converting structure.

3. The light emitting device of claim 1, wherein the top light emitting surface of the wavelength converting structure is recessed with respect to the planar top surface of the reflective structure.

4. The light emitting device of claim 3, comprising a transparent layer (650) disposed on the top light emitting surface of the wavelength converting structure.

5. The light emitting device of claim 4, wherein an outer surface of the transparent layer (650) opposite from the wavelength converting structure (620) is coplanar with the planar top surface of the reflective structure.

6. The light emitting device of claim 1, wherein the wavelength converting structure (620) is or comprises a ceramic phosphor plate.

7. The light emitting device of claim 1, wherein the light absorbing layer (660) comprises light absorbing material dispersed in a binder.

8. The light emitting device of claim 1, wherein the reflective material includes at least one or more of SiO₂ particles, Al₂O₃ particles, and TiO₂ particles.

9. The light emitting device of claim 1, comprising a transparent layer (630) disposed on the top light emitting surface of the wavelength converting structure (620); wherein:
the top light emitting surface of the wavelength converting structure is recessed with respect to the planar top surface of the reflective structure (640);
an outer surface of the transparent layer opposite from the wavelength converting phosphor structure is coplanar with the planar top surface of the reflective structure.

10. A method of manufacturing a light emitting device, the method comprising:
providing a wavelength-converted light emitting diode comprising a light emitting diode (610) and a wavelength converting structure (620), the wavelength-converted light emitting diode having a top light emitting surface, an oppositely positioned bottom surface, and side surfaces connecting the top and bottom surfaces;
covering the top light emitting surface and the side surfaces with a reflective material (640);
removing reflective material to expose the top light emitting surface and to form a planar top surface of the reflective material adjacent to and parallel to the top light emitting surface, the planar top surface being disposed at a same level as the top light emitting surface or above the top light emitting surface in a vertical direction perpendicular to the planar top surface; and
depositing a light absorbing layer (660) on the planar top surface of the reflective material, and separated from outer edges of the top surface of the wavelength converting structure by a gap having a width of between 30 microns and 60 microns measured perpendicularly to a side surface of the wavelength converting structure.

11. The method of claim 10, wherein
the wavelength-converted light emitting diode comprises a sacrificial transparent layer (630) disposed on the wavelength converting structure;
the top light emitting surface is a surface of the transparent layer (630); and
removing reflective material comprises grinding and planarizing the reflective material and the sacrificial layer to create a new planar top light emitting surface of the wavelength converting structure (620) coplanar with the planar top surface of the light reflective material.

12. The method of claim 10, comprising depositing the reflective material on the top light emitting surface and the side surfaces by overmolding.

13. The method of claim 10, wherein depositing the light absorbing layer (660) comprises screen printing the light absorbing layer on the planar top surface of the reflective material.

## Patentansprüche

1. Lichtemittierende Vorrichtung (600D), die aufweist:
eine Leuchtdiode (610), die eine obere Lichtaustrittsfläche, eine entgegensetzt positionierte untere Fläche, und Seitenflächen aufweist, welche die obere und untere Fläche verbinden;
eine Wellenlängenkonversionsstruktur (620), die eine obere Lichtaustrittsfläche, eine entgegensetzt positionierte untere Fläche, und Seitenflächen aufweist, welche die obere und die untere Fläche verbinden, wobei die untere Fläche der Wellenlängenkonversionsstruktur auf oder angrenzend an die obere Fläche der Leuchtdiode angeordnet ist;
eine reflektierende Struktur (640), die ein reflektierendes Material aufweist, das auf den Seitenfläche der Leuchtdiode und auf Seitenflächen der Wellenlängenkonversionsstruktur angeordnet ist, wobei die reflektierende Struktur eine planare obere Fläche aufweist, die angrenzend an und parallel zu der oberen Fläche der Wellenlängenkonversionsstruktur angeordnet ist, wobei die planare obere Fläche auf gleicher Höhe wie die obere Fläche der Wellenlängenkonversionsstruktur oder oberhalb der oberen Fläche der Wellenlängenkonversionsstruktur in einer vertikalen Richtung senkrecht zu der planaren oberen Fläche angeordnet ist; und
eine Lichtabsorptionsschicht (660), die auf der planaren oberen Fläche der reflektierenden Struktur positioniert ist und von den Außenrändern der oberen Fläche der Phosphor-Wellenlängenkonversionsstruktur um einen Spalt (661) getrennt ist, der eine Breite zwischen 30 Mikrometern und 60 Mikrometern aufweist, und zwar senkrecht zu einer Seitenfläche der Phosphor-Wellenlängenkonversionsstruktur gemessen.

2. Lichtemittierende Vorrichtung nach Anspruch 1, wobei die planare obere Fläche der reflektierenden Struktur (640) komplanar mit der oberen Lichtaustrittsfläche der Wellenlängenkonversionsstruktur ist.

3. Lichtemittierende Vorrichtung nach Anspruch 1, wobei die obere Lichtaustrittsfläche der Wellenlängenkonversionsstruktur in Bezug auf die planare obere Fläche der reflektierenden Struktur ausgespart ist.

4. Lichtemittierende Vorrichtung nach Anspruch 3, die eine transparente Schicht (650) aufweist, die auf der oberen Lichtaustrittsfläche der Wellenlängenkonversionsstruktur angeordnet ist.

5. Lichtemittierende Vorrichtung nach Anspruch 4, wobei eine Außenfläche der transparenten Schicht (650) entgegengesetzt zu der Wellenlängenkonversionsstruktur (620) komplanar mit der planaren oberen Fläche der reflektierenden Struktur ist.

6. Lichtemittierende Vorrichtung nach Anspruch 1, wobei die Wellenlängenkonversionsstruktur (620) eine Keramik-Phosphorplatte ist oder aufweist.

7. Lichtemittierende Vorrichtung nach Anspruch 1, wobei die Lichtabsorptionsschicht (660) Lichtabsorptionsmaterial aufweist, das in einem Bindemittel dispergiert ist.

8. Lichtemittierende Vorrichtung nach Anspruch 1, wobei das reflektierende Material mindestens eines oder mehreres aus SiO₂-Partikels, Al₂O₃-Partikeln, und TiO₂-Partikeln aufweist.

9. Lichtemittierende Vorrichtung nach Anspruch 1, wobei eine transparente Schicht (630) auf der oberen Lichtaustrittsfläche der Wellenlängenkonversionsstruktur (620) angeordnet ist; wobei:
die obere Lichtaustrittsfläche der Wellenlängenkonversionsstruktur in Bezug auf die planare obere Fläche der reflektierenden Struktur (640) ausgespart ist;
eine Außenfläche der transparenten Schicht entgegengesetzt zu der Phosphor-Wellenlängenkonversionsstruktur komplanar mit der planaren oberen Fläche der reflektierenden Struktur ist.

10. Verfahren zur Herstellung einer lichtemittierenden Vorrichtung, wobei das Verfahren umfasst:
Bereitstellen einer wellenlängenkonvertierten Leuchtdiode, die eine Leuchtdiode (610) und eine Wellenlängenkonversionsstruktur (620) aufweist, wobei die wellenlängenkonvertierte Leuchtdiode eine obere Lichtaustrittsfläche, eine entgegensetzt positionierte untere Fläche, und Seitenflächen aufweist, welche die obere und die untere Fläche verbinden;
Bedecken der oberen Lichtaustrittsfläche und der Seitenflächen mit einem reflektierenden Material (640);
Entfernen des reflektierenden Materials, um die obere Lichtaustrittsfläche freizulegen und eine planare obere Fläche des reflektierenden Materials angrenzend an und parallel zu der oberen Lichtaustrittsfläche zu bilden, wobei die planare obere Fläche auf der gleichen Höhe wie die obere Lichtaustrittsfläche oder oberhalb der oberen Lichtaustrittsfläche in einer vertikalen Richtung senkrecht zu der planaren oberen Fläche angeordnet ist; und
Aufbringen einer Lichtabsorptionsschicht (660) auf der planaren oberen Fläche des reflektierenden Materials und getrennt von Außenrändern der oberen Fläche der Wellenlängenkonversionsstruktur um einen Spalt, der eine Breite zwischen 30 Mikrometern und 60 Mikrometern aufweist, und zwar senkrecht zu einer Seitenfläche der Wellenlängenkonversionsstruktur gemessen.

11. Verfahren nach Anspruch 10, wobei die wellenlängenkonvertierte Leuchtdiode eine transparente Opferschicht (630) aufweist, die auf der Wellenlängenkonversionsstruktur angeordnet ist;
wobei die obere Lichtaustrittsfläche eine Fläche der transparenten Schicht (630) ist; und
wobei das Entfernen des reflektierenden Materials das Schleifen und Planarisieren des reflektierenden Materials und der Opferschicht umfasst, um eine neue planare obere Lichtaustrittsfläche der Wellenlängenkonversionsstruktur (620) komplanar mit der planaren oberen Fläche des lichtreflektierenden Materials zu bilden.

12. Verfahren nach Anspruch 10, welches das Aufbringen des reflektierenden Materials auf der oberen Lichtaustrittsfläche und den Seitenfläche durch Überspritzen umfasst.

13. Verfahren nach Anspruch 10, wobei das Aufbringen der Lichtabsorptionsschicht (660) das Siebdrucken der Lichtabsorptionsschicht auf die planare obere Fläche des reflektierenden Materials umfasst.

## Revendications

1. Dispositif électroluminescent (600D) comprenant :
une diode électroluminescente (610) comprenant une surface supérieure électroluminescente, une surface inférieure positionnée de manière opposée, et des surfaces latérales reliant les surfaces supérieure et inférieure ;
une structure de conversion de longueur d'onde (620) comprenant une surface supérieure électroluminescente, une surface inférieure positionnée de manière opposée, et des surfaces latérales reliant les surfaces supérieure et inférieure, la surface inférieure de la structure de conversion de longueur d'onde étant disposée sur ou adjacente à la surface supérieure de la diode électroluminescente ;
une structure réfléchissante (640) comprenant un matériau réfléchissant disposé sur les surfaces latérales de la diode électroluminescente et sur les surfaces latérales de la structure de conversion de longueur d'onde, la structure réfléchissante comprenant une surface supérieure plane agencée adjacente et parallèle à la surface supérieure de la structure de conversion de longueur d'onde, la surface supérieure plane étant disposée au même niveau que la surface supérieure de la structure de conversion de longueur d'onde ou au-dessus de la surface supérieure de la structure de conversion de longueur d'onde dans une direction verticale perpendiculaire à la surface supérieure plane ; et
une couche absorbant la lumière (660) positionnée sur la surface supérieure plane de la structure réfléchissante, et séparée des bords extérieurs de la surface supérieure de la structure de luminophore de conversion de longueur d'onde par un espace (661) ayant une largeur comprise entre 30 microns et 60 microns, mesurée perpendiculairement à une surface latérale de la structure de luminophore de conversion de longueur d'onde.

2. Dispositif électroluminescent selon la revendication 1, dans lequel la surface supérieure plane de la structure réfléchissante (640) est coplanaire avec la surface supérieure électroluminescente de la structure de conversion de longueur d'onde.

3. Dispositif électroluminescent selon la revendication 1, dans lequel la surface supérieure électroluminescente de la structure de conversion de longueur d'onde est en retrait par rapport à la surface supérieure plane de la structure réfléchissante.

4. Dispositif électroluminescent selon la revendication 3, comprenant une couche transparente (650) disposée sur la surface supérieure électroluminescente de la structure de conversion de longueur d'onde.

5. Dispositif électroluminescent selon la revendication 4, dans lequel la surface extérieure de la couche transparente (650), opposée à la structure de conversion de longueur d'onde (620), est coplanaire avec la surface supérieure plane de la structure réfléchissante.

6. Dispositif électroluminescent selon la revendication 1, dans lequel la structure de conversion de longueur d'onde (620) est ou comprend une plaque de luminophore céramique.

7. Dispositif électroluminescent selon la revendication 1, dans lequel la couche absorbant la lumière (660) comprend un matériau absorbant la lumière dispersé dans un liant.

8. Dispositif électroluminescent selon la revendication 1, dans lequel le matériau réfléchissant comprend au moins une ou plusieurs parmi les particules de SiO₂, les particules d'Al₂O₃ et les particules de TiO₂.

9. Dispositif électroluminescent selon la revendication 1, comprenant une couche transparente (630) disposée sur la surface supérieure électroluminescente de la structure de conversion de longueur d'onde (620) ; dans lequel :
la surface supérieure électroluminescente de la structure de conversion de longueur d'onde est en retrait par rapport à la surface supérieure plane de la structure réfléchissante (640) ;
une surface extérieure de la couche transparente opposée à la structure de de luminophore de conversion de longueur d'onde est coplanaire avec la surface supérieure plane de la structure réfléchissante.

10. Procédé de fabrication d'un dispositif électroluminescent, le procédé comprenant :
la fourniture d'une diode électroluminescente à conversion de longueur d'onde comprenant une diode électroluminescente (610) et une structure de conversion de longueur d'onde (620), la diode électroluminescente à conversion de longueur d'onde ayant une surface supérieure électroluminescente, une surface inférieure positionnée de manière opposée et des surfaces latérales reliant les surfaces supérieure et inférieure ;
le recouvrement de la surface supérieure électroluminescente et des surfaces latérales avec un matériau réfléchissant (640) ;
le retrait du matériau réfléchissant pour exposer la surface supérieure électroluminescente et former une surface supérieure plane du matériau réfléchissant adjacente et parallèle à la surface supérieure électroluminescente, la surface supérieure plane étant disposée au même niveau que la surface supérieure électroluminescente ou au-dessus de la surface supérieure électroluminescente dans une direction verticale perpendiculaire à la surface supérieure plane ; et
le dépôt d'une couche absorbant la lumière (660) sur la surface supérieure plane du matériau réfléchissant, et séparée des bords extérieurs de la surface supérieure de la structure de conversion de longueur d'onde par un espace ayant une largeur comprise entre 30 microns et 60 microns, mesurée perpendiculairement à une surface latérale de la structure de conversion de longueur d'onde.

11. Procédé selon la revendication 10, dans lequel la diode électroluminescente à conversion de longueur d'onde comprend une couche sacrificielle transparente (630) disposée sur la structure de conversion de longueur d'onde ;
la surface supérieure électroluminescente est une surface de la couche transparente (630) ; et
le retrait du matériau réfléchissant comprend le meulage et la planarisation du matériau réfléchissant et de la couche sacrificielle afin de créer une nouvelle surface supérieure électroluminescente plane de la structure de conversion de longueur d'onde (620), coplanaire avec la surface supérieure plane du matériau réfléchissant la lumière.

12. Procédé selon la revendication 10, comprenant le dépôt du matériau réfléchissant sur la surface supérieure électroluminescente et les surfaces latérales par surmoulage.

13. Procédé selon la revendication 10, dans lequel le dépôt de la couche absorbant la lumière (660) comprend la sérigraphie de la couche absorbant la lumière sur la surface supérieure plane du matériau réfléchissant.
